# EUROPÄISCHE PATENTSCHRIFT

(11) **EP 4 312 031 B1**
(45) Veröffentlichungstag und Bekanntmachung des Hinweises auf die Patenterteilung: **08.04.2026**
(21) Anmeldenummer: 23184892.0
(22) Anmeldetag: 12.07.2023
(51) Int. Cl.: G01R 1/20, G01R 15/20, G01R 35/00

(54) **STROMSENSOR**
CURRENT SENSING DEVICE
CAPTEUR DE COURANT

(30) Priorität: 29.07.2022 DE 102022207853
(43) Veröffentlichungstag der Anmeldung: 31.01.2024
(73) Patentinhaber: AUMOVIO Germany GmbH, 60488 Frankfurt am Main (DE)
(72) Erfinder: Lehmann, Sören, 60488 Frankfurt am Main (DE); Irsigler, Michael, 60488 Frankfurt am Main (DE); Gopinath, Anjana, 60488 Frankfurt am Main (DE); Weigert, Wolfgang, 60488 Frankfurt am Main (DE); Frimberger, Manfred, 60488 Frankfurt am Main (DE)
(74) Vertreter: Aumovio Corporation

(56) Entgegenhaltungen:
- EP-A1- 1 213 189
- DE-A1- 102014 216 419
- JP-A- 2009 281 773
- KR-A- 20160 111 166
- US-A1- 2014 212 714
- US-A1- 2017 261 536

## Beschreibung

Die Erfindung betrifft einen Stromsensor, insbesondere für eine Fahrzeugbatterie in einem Fahrzeug, mit einem elektrischen Leiter, der einen ersten Anschluss und einen zweiten Anschluss zu Kontaktierung mit einem Stromkreis eines Fahrzeugs aufweist, sowie mit einer ersten Strommesseinrichtung und einer zweiten Strommesseinrichtung zur Erfassung zumindest eines Messwertes für den über den elektrischen Leiter fließenden Strom, und mit einer ersten Auswerteschaltung, die mit der ersten Strommesseinrichtung und/oder der zweiten Strommesseinrichtung verbunden ist und die Messwerte der ersten Strommesseinrichtung und/oder der zweiten Strommesseinrichtung empfangen und zumindest ein von den Messwerten abhängiges Strommesssignal ausgeben kann.

In Fahrzeugen mit Batterien, insbesondere in Elektrofahrzeugen oder Hybridfahrzeugen, bei welchen Batterien für die Energieversorgung des Antriebs verwendet werden, ist es erforderlich die Batterien bzw. deren Zustand während des Betriebes permanent zu überwachen. Insbesondere ist es erforderlich, den Ladezustand der Batterien permanent zu überwachen. In den Fahrzeugen werden hierzu Stromsensoren verwendet, die im Strompfad angeordnet sind und sowohl die Ladeströme wie auch die Entladeströme der Batterien erfassen.

Um die im Automobilbereich geforderte Ausfallsicherheit zu gewährleisten und die geforderte Genauigkeit der Strommessung sicherzustellen, ist es erforderlich, eine redundante Strommessung bereitzustellen. Beispiele für eine solche redundante Strommessung sind in der JP 2009 28 1773 A, der DE 10 2014 216 419 A1, der US 2014 212 714 A1 oder der KR 2016 0111166 A gezeigt. Vorzugsweise erfolgt diese redundante Strommessung mit zwei voneinander unabhängigen physikalische Messprinzipien, um Messfehler aufgrund von systematischen Fehlern beziehungsweise aufgrund von Fehlern, die einem Messprinzip anhaften können, zu vermeiden bzw. zu minimieren. Die Verwendung verschiedener Messprinzipien wird auch als asymmetrische Redundanz bezeichnet. Ein solcher Sensor ist beispielsweise in der EP2732295A1, der EP 1 213 189 A1 oder der US 2017/261536 A1 gezeigt.

Die EP 1 213 189 A1 handelt von einer Einrichtung zur Überwachung eines Bordnetztes eines Fahrzeuges mit einem Sensor, wobei ein zweiter Sensor zur Messung des Stromes in einer Anschlussleitung vorgesehen ist, dessen Messbereich von dem Messbereich des ersten Sensors verschieden ist und wenigstens einer der beiden Sensoren für eine potentialfreie Messung des Stromes ausgebildet ist.

Die US 2017 261 536 A1 handelt von einer Hybrid-Stromsensor-Vorrichtung mit einem elektrischen Leiter, einem Hallsensor-Modul zur Detektion des Stromflusses in dem elektrischen Leiter und einem Shunt-Sensor-Modul zur Detektion des Stromflusses in dem elektrischen Leiter.

Die JP 2009 281 773 A handelt von einem Shunt-Widerstands-Sensor der den Stromfluss in einem elektrischen Leiter mittels eines Shunt-Widerstands sowie einem Hall-Sensor ermittelt, wobei Schaltvorrichtungen zur Erzeugung eines Offset-Wertes aus den Sensorsignalen sowie eine Offset-Entfernungs-Vorrichtung vorgesehen ist, die den Offset von den Sensorsignalen entfernt.

Die DE 10 2014 216 419 A1 offenbart ein Verfahren zur Überprüfung mindestens einer Messeinrichtung ur Messung eines durch den Strompfad fließenden elektrischen Stromes, wobei eine weitere Recheneinrichtung zur Kontrolle der ordnungsgemäßen Steuerung und/oder Regelung der Messung der mindestens einen Messeinrichtung durch deren Recheneinrichtung vorgesehen ist, die mit dieser Recheneinrichtung der mindestens einen Messeinrichtung mittels Frage-Antwort Kommunikation kommuniziert.

Die US 2014 212 714 A1 handelt von einem Batterie-Management-System, wobei ein erster Mikrokontroller dazu ausgebildet ist, durch eine erste Messeinheit erfasste Messdaten auszuwerten und ein zweiter Mikrokontroller, der dazu ausgebildet ist, durch eine von der ersten Messeinheit unabhängigen zweiten Messeinheit erfasste Messdaten auszuwerten.

Die KR 2016 111 166 A offenbart eine Shunt-Sensor-Kompensationsvorrichtung umfassend eine Batterie, einen Hallsensor und einen Shunt-Sensor, wobei eine Steuereinheit über die Zeit gesammelte Differenz-Daten des Stromwertes von einer Integrationseinheit erhält und den Stromwert des Shunt-Sensors kompensiert durch akkumulieren oder addieren der gesammelten Summen-Daten als ein Shunt-Sensor-Kompensations-Wert.

Der Aufbau und die Herstellung solcher Sensoren ist aber sehr aufwendig.

Aufgabe der Erfindung ist es, einen Stromsensor mit einer redundanten Strommessung bereitzustellen, der eine hohe Messgenauigkeit sowie eine hohe Ausfallsicherheit aufweist und einfach herzustellen ist.

Zu Lösung der Aufgabe ist ein Stromsensor, insbesondere für eine Fahrzeugbatterie in einem Fahrzeug, vorgesehen, mit einem elektrischen Leiter, der einen ersten Anschluss und einen zweiten Anschluss zur Kontaktierung mit einem Stromkreis eines Fahrzeugs aufweist, sowie mit einer ersten Strommesseinrichtung und einer zweiten Strommesseinrichtung zur Erfassung zumindest eines Messwertes für den über den elektrischen Leiter fließenden Strom. Die zweite Strommesseinrichtung ist elektrisch in Reihe zur ersten Strommesseinrichtung angeordnet. Der Stromsensor weist des Weiteren eine erste Auswerteschaltung auf, die mit der ersten Strommesseinrichtung und/oder der zweiten Strommesseinrichtung verbunden ist und die Messwerte der ersten Strommesseinrichtung und/oder der zweiten Strommesseinrichtung empfangen und ein von den Messwerten abhängiges Strommesssignal ausgeben kann. Die erste Strommesseinrichtung weist einen Hall-Sensor auf. Der elektrische Leiter weist im Bereich der ersten Strommesseinrichtung eine Messabschnitt mit einer Einschnürung mit einem reduzierten Querschnitt auf, wobei der Hall-Sensor in dieser Einschnürung angeordnet ist. Der Stromsensor weist eine erste Kommunikationsschnittstelle zur Ausgabe der Messwerte der ersten Strommesseinrichtung sowie eine zweite Kommunikationsschnittstelle zur Ausgabe des Strommesssignals der zweiten Strommesseinrichtung auf.

Es ist eine zweite Auswerteschaltung vorgesehen, wobei zwischen der ersten Auswerteschaltung und der zweiten Auswerteschaltung eine Kommunikationsverbindung vorgesehen ist. Die erste Auswerteschaltung kann ein erstes Testsignal an die zweite Auswerteschaltung senden und/oder die zweite Auswerteschaltung kann ein zweites Testsignal an die erste Auswerteschaltung senden. Die erste Auswerteschaltung kann das zweite Testsignal prüfen und/oder die zweite Auswerteschaltung kann das erste Testsignal prüfen. Die erste Auswerteschaltung kann bei einer Abweichung des zweiten Testsignals von einem zweiten Referenzwert ein erstes Korrektursignal senden und die zweite Auswerteschaltung kann bei Abweichung des ersten Testsignals von einem ersten Referenzwert ein zweites Korrektursignal senden.

Dies kann mehrere Vorteile haben. Zum einen kann durch die Auswertung der Messwerte außerhalb des Stromsensors zusätzlich die Funktion des Stromsensors, insbesondere der Auswerteschaltung, überprüft werden.

Beispielsweise werden die Messwerte der ersten Strommesseinrichtung nicht ausgewertet, sondern lediglich ausgegeben, sodass diese, beispielsweise von einer nachgeordneten Fahrzeugsteuerung, ausgewertet werden können. Die Messwerte der zweiten Strommesseinrichtung werden dagegen ausgewertet und lediglich ein Strommesssignal ausgegeben.

Üblicherweise wird ein Hall-Sensor mit einem Eisenkern verwendet, der den elektrischen Leiter in Umfangsrichtung umschließt. Der Hall-Sensor ist in einem Spalt des Eisenkerns angeordnet. Durch den elektrischen Strom, der durch den elektrischen Leiter fließt, wird im Eisenkern ein Magnetfeld erzeugt, dass vom Hall-Sensor erfasst werden kann. Die Anordnung eines solchen Eisenkerns sowie die Positionierung des Hall-Sensors ist aber sehr aufwendig. Erfindungsgemäß wird statt eines Hall-Sensors mit einem Eisenkern ein sogenannter Differenz-Hall-Sensor verwendet. Im elektrischen Leiter ist eine Aussparung vorgesehen, in der der Hall-Sensor positioniert wird. Das in dieser Einschnürung bzw. in dieser Aussparung durch den elektrischen Strom erzeugte Magnetfeld ist stark genug, sodass dieses von dem Hall-Sensor erfasst werden kann. Somit kann auf einen Eisenkern zur Erzeugung beziehungsweise zur Verstärkung des Magnetfeldes verzichtet werden. Der Stromsensor kann somit wesentlich kompakter ausgebildet werden. Zudem ist der Aufbau wesentlich einfacher, da lediglich der Hall-Sensor in der Aussparung positioniert bzw. ausgerichtet werden muss. Eine zusätzliche Ausrichtung und Positionierung des Eisenkerns sowie des Hall-Sensors an diesem Eisenkern sind nicht erforderlich.

Insbesondere ist die Einschnürung so angeordnet, dass innerhalb der Einschnürung ein möglichst starkes Magnetfeld bereitgestellt wird, das durch den Hall-Sensor erfasst werden kann. Insbesondere kann die Geometrie der Einschnürung unter Berücksichtigung der geometrischen Form des elektrischen Leiters, des Messbereichs und der Abmessungen des Hall-Sensors oder einer gewünschten Stärke des zu messenden Magnetfeldes festgelegt werden.

Beispielsweise kann die Einschnürung durch zumindest einen Schlitz gebildet sein, der von zumindest einer Fläche und oder einem Rand des elektrischen Leiters aus erstreckt. Ein solcher Schlitz ist einfach herzustellen und ermöglicht eine einfache Positionierung des Hall-Sensors in diesem Schlitz.

Die Einschnürung kann bezüglich einer in Stromrichtung verlaufenden Mittelachse des elektrischen Leiters symmetrisch, insbesondere bezüglich einer durch die Mittelachse verlaufenden Ebene spiegelbildlich ausgebildet sein. Dadurch erfolgt eine bezüglich der Mittelachse asymmetrische, insbesondere spiegelbildliche Beeinflussung der Stromlinien bzw. der Potenziallinien, sodass ein möglichst homogenes Magnetfeld erzeugt werden kann.

Beispielsweise kann der elektrische Leiter plattenförmig ausgebildet sein und die Einschnürung ist durch zwei von gegenüberliegenden Rändern des Leiters ausgehenden Schlitzen, die sich bezüglich der Mittelachse symmetrisch in den elektrischen Leiter erstrecken, gebildet.

Die zweite Strommesseinrichtung nutzt vorzugsweise ein anderes physikalisches Messprinzip als die erste Strommesseinrichtung. Beispielweise kann die zweite Strommesseinrichtung einen Messwiderstand sowie zumindest einen ersten Messkontakt zur Erfassung eines ersten Spannungspotenzials und zumindest einen zweiten Messkontakt zur Erfassung eines zweiten Spannungspotenzials aufweisen, wobei die erste Messkontakt und der zweite Messkontakt in Stromrichtung versetzt angeordnet sind. Insbesondere kann der erste Messkontakt in Längsrichtung des elektrischen Leiters vor dem Messwiderstand und der zweiten Messkontakt hinter dem Messwiderstand angeordnet sein. Durch die gemessenen Spannungspotenziale kann der Spannungsabfall über den Messwiderstand ermittelt werden. Aus dem bekannten elektrischen Widerstand des Messwiderstandes bzw. einer Messstrecke zwischen den Messkontakten sowie dem gemessenen Spannungsabfall kann über das ohmsche Gesetz der über den Messwiderstand bzw. die Messstrecke, also den elektrischen Leiter, fließende Strom berechnet werden.

Insbesondere kann auch für die zweite Strommesseinrichtung eine symmetrische Ausbildung der Einschnürung der ersten Strommesseinrichtung vorteilhaft sein, da durch diese eine symmetrische Beeinflussung der Stromlinien bzw. der Potenziallinien erfolgt.

Beide Strommesseinrichtung sind beispielsweise mit der ersten Auswerteschaltung kontaktiert, die die Messwerte beider Strommesseinrichtungen verarbeitet und ein gemeinsames Strommesssignal oder ein Strommesssignal für jede der Strommesseinrichtungen erzeugt.

Die zweite Auswerteschaltung kann lediglich die Funktion einer Überwachungsschaltung aufweisen und keine Auswertung der Messwerte der Strommesseinrichtungen übernehmen. Optional kann aber auch die zweite Auswerteschaltung die Messwerte der Strommesseinrichtungen empfangen und diese auswerten.

Grundsätzlich haben die erste und die zweite Auswerteschaltung die Funktion, sich gegenseitig zu überwachen und bei einer Fehlfunktion der jeweils anderen Auswerteschaltung geeignete Maßnahmen zu veranlassen, um die Fehlfunktion der jeweils anderen Auswerteschaltung zu beheben. Stellt eine der Auswerteschaltungen eine Fehlfunktion der jeweils anderen Auswerteschaltung fest, wird ein Korrektursignal gesendet, aufgrund dessen eine geeignete Maßnahme für die jeweils andere Auswerteschaltung veranlasst wird.

Durch die gegenseitige Überprüfung der Auswerteschaltungen ist innerhalb des Stromsensors eine erhöhte Sicherheit bereitgestellt, da Fehlfunktionen innerhalb des Stromsensors erkannt und korrigiert werden können.

Die Kommunikationsverbindung ist beispielsweise eine bidirektionale Verbindung, wobei die Testsignale beider Auswerteschaltung über diese Verbindung gesendet werden. Die Kommunikationsverbindung kann aber auch mehrere Leitungen aufweisen, beispielsweise für jedes Testsignal eine separate Leitung, um Fehler in der Kommunikationsverbindung erkennen zu können.

Beispielsweise kann die erste Auswerteschaltung eine erste Korrekturschaltung zum Empfang des ersten Korrektursignal und die zweite Auswerteschaltung eine zweite Korrekturschaltung zum Empfang des zweiten Korrektursignal aufweisen, wobei die erste Korrekturschaltung zum Auslösen eines Korrekturvorgangs für die erste Auswerteschaltung und die zweite Korrekturschaltung zum Auslösen eines Korrekturvorgangs für die zweite Auswerteschaltung vorgesehen ist. Die Maßnahmen zur Korrektur der Fehlfunktion werden nach Initiierung durch die jeweils andere Auswerteschaltung mit dem Korrektursignal durch die jeweilige Auswerteschaltung selbst veranlasst, wobei über das Senden des Testsignals anschließend eine Überprüfung durch die jeweils andere Auswerteschaltung erfolgen kann, ob die Korrektur der Fehlfunktion erfolgreich war.

Der Korrekturvorgang der der ersten und/oder der zweiten Auswerteschaltung umfasst beispielsweise einen Neustart der Auswerteschaltung und/oder ein Zurücksetzen der Auswerteschaltung. Insbesondere können die erste Auswerteschaltung und/oder die zweite Auswerteschaltung eine erste bzw. eine zweite Korrekturschaltung aufweisen, die das Korrektursignal empfängt und Korrekturmaßnahmen, insbesondere einen Neustart oder ein Zurücksetzen der jeweiligen Auswerteschaltung veranlasst. Durch eine zusätzliche Korrekturschaltung ist sichergestellt, dass das Auslösen der Korrekturmaßnahmen nicht durch eine fehlerhafte Auswerteschaltung selbst verhindert wird.

Das Testsignal kann verschiedene Informationen enthalten, die eine Diagnose der jeweils anderen Auswerteschaltung ermöglichen. Für die mit dem Testsignal gesendeten Informationen sind vorzugsweise in der jeweiligen Auswerteschaltung Referenzwerte gespeichert oder diese werden von der jeweiligen Auswerteschaltung selbst empfangen oder ermittelt. Insbesondere können für die Informationen Schwellwerte definiert werden, um die die Informationen von den Referenzwerten abweichen können.

Insbesondere werden die Testsignale periodisch, insbesondere in regelmäßigen zeitlichen Abständen versendet. Dadurch kann zusätzlich das Ausbleiben eines Testsignals detektiert werden und als Fehlfunktion der jeweiligen Auswerteschaltung erkannt werden. Optional kann auch ein Anforderungssignal gesendet werden, dass die jeweilige Auswerteschaltung zum Senden des Testsignal veranlasst.

Beispielsweise können auch zusätzliche Informationen über das Anforderungssignal angefordert werden, um eine genauere Diagnose der jeweils anderen Auswerteschaltung durchführen zu können.

Beispielsweise beinhaltet das erste Testsignal Statusinformationen und/oder Betriebsinformationen der ersten Auswerteschaltung und/oder das zweite Testsignal Statusinformationen und/oder Betriebsinformationen der zweiten Auswerteschaltung. Weichen diese Statusinformationen und/oder diese Betriebsinformationen von vorab definierten Parametern ab, muss von einer Fehlfunktion der jeweiligen Auswerteschaltung ausgegangen werden, sodass Korrekturmaßnahmen erforderlich sind.

Das erste Testsignal kann auch Messwerte und/oder ein Strommesssignal der ersten Auswerteschaltung beinhalten und/oder das zweite Testsignal kann Messwerte und/oder ein Strommesssignal der zweiten Auswerteschaltung beinhalten. Durch den Vergleich der Messwerte und/oder der Strommesssignale kann nicht nur überprüft werden, ob die jeweilige Auswerteschaltung funktioniert, sondern auch, ob diese die Messwerte der jeweiligen Strommesseinrichtung korrekt empfängt und auswertet.

Des Weiteren kann das erste Testsignal und/oder das zweite Testsignal Statusinformationen und/oder Betriebsinformationen der ersten Strommesseinrichtung und/oder der zweiten Strommesseinrichtung beinhalten.

Um die Zuverlässigkeit des Stromsensors bzw. der Funktionsprüfung zu verbessern, können die erste Auswerteschaltung und die zweite Auswerteschaltung separate Stromversorgungen und/oder separate Ausgänge für ein Strommesssignal aufweisen. Durch eine getrennte Stromversorgung der beiden Auswerteschaltungen kann sichergestellt werden, dass Funktionsfehler aufgrund einer fehlerhaften Spannungsversorgung sich nicht auf beide Auswerteschaltungen auswirken. Dadurch kann eine Fehlfunktion einer der beiden Auswerteschaltungen zuverlässiger erkannt werden. Die getrennten Ausgänge für das Strommesssignal ermöglichen die getrennte Ausgabe der Strommesssignale. Diese können dadurch beispielsweise über die Kommunikationsverbindung versendet werden oder separat einer übergeordneten Fahrzeugsteuerung zur Verfügung gestellt werden. Insbesondere kann in einer übergeordneten Fahrzeugsteuerung eine weitere Verarbeitung der Strommesssignale erfolgen, beispielsweise ein zusätzlicher Vergleich der Messwerte oder der Strommesssignale beider Auswerteschaltungen.

Die Messwerte und/oder die Strommesssignale können jeweils analog oder digital ausgegeben werden. Beispielsweise werden die Strommesssignale der zweiten Strommesseinrichtung digital ausgegeben und die Messwerte der ersten Strommesseinrichtung werden analog, insbesondere ohne vorherige Aufbereitung oder Auswertung, ausgegeben.

Aufgrund der hohen Spannungen und Ströme kann es erforderlich sein, Teile des Stromsensors, insbesondere der Auswerteschaltung gegenüber den Kommunikationsschnittstellen und einer nachgeordneten Fahrzeugsteuerung gegen einen Spannungsüberschlag zu sichern, beispielsweise durch eine galvanische Trennung. Insbesondere stehen bei einer zweiten Strommesseinrichtung mit einem Messwiderstand die Messkontakte in direktem Kontakt mit dem elektrischen Leiter sowie der Auswerteschaltung, sodass die Auswerteschaltung besonders gegen einen Spannungsüberschlag zur Fahrzeugsteuerung oder anderen Teilen des Stromsensors geschützt werden muss. Ein Hall-Sensor arbeitet dagegen berührungslos, sodass es nicht erforderlich sein kann, diesen gegen einen Spannungsüberschlag zu schützen. Da die erste Strommesseinrichtung in dieser Ausführungsform eine separate Kommunikationsschnittstelle zur Ausgabe der Messwerte aufweist, ist keine elektrische Verbindung zu einer der Auswerteschaltungen erforderlich. Eine Isolierung oder ein Schutz gegenüber den Bereichen, die mit einer hohen Spannung in Kontakt gelangen können, ist somit nicht erforderlich. Dadurch kann der Aufbau des Stromsensors wesentlich einfacher gestaltet sein. Insbesondere ist es nicht erforderlich, die Kommunikationsschnittstelle der ersten Strommesseinrichtung zusätzlich gegen Spannungsüberschläge zu schützen.

Unabhängig von der Ausführungsform können aber auch die erste Kommunikationsschnittstelle und/oder die zweite Kommunikationsschnittstelle Schutzeinrichtungen gegen eine positive und/oder negative Überspannung und/oder für eine Potentialtrennung aufweisen.

Des Weiteren können die erste Auswerteschaltung und/die zweite Auswerteschaltung eine Isolation, insbesondere eine galvanische Trennung, aufweisen, durch die die erste Auswerteschaltung und/oder die zweite Auswerteschaltung gegenüber anderen Bereichen des Stromsensors oder anderen Teilen eines Fahrzeugs isoliert ist.

Weitere Vorteile und Merkmale ergeben sich aus der nachfolgenden Beschreibung in Verbindung mit den beigefügten Zeichnungen. in diesen zeigen
- Figur 1: eine erste Ausführungsform eines erfindungsgemäßen Stromsensors, und
- Figur 2: zweite Ausführungsform eines erfindungsgemäßen Stromsensors.

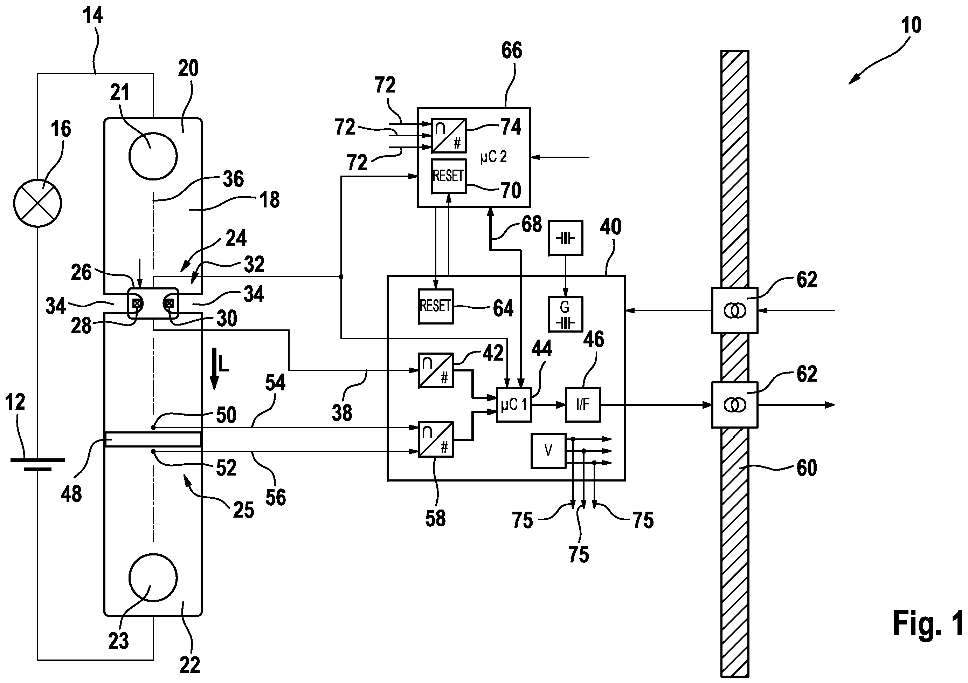

**In** Figur 1 ist ein Batteriesensor 10 für eine Fahrzeugbatterie 12 in einem Fahrzeug gezeigt. Der Batteriesensor 10 ist in einem Stromkreis 14 angeordnet, in dem sich die Fahrzeugbatterie 12 sowie zumindest ein Verbraucher 16 befinden, wobei der Batteriesensor 10 so angeordnet ist, dass sämtliche Ladeströme und Entladeströme der Fahrzeugbatterie 12 über den Batteriesensor 10 fließen und somit von diesen gemessen werden können. Über die gemessenen Ladeströme und Entladeströme ist eine sehr genaue Aussage über den Ladezustand der Fahrzeugbatterie 12 möglich.

Der Batteriesensor 10 hat einen elektrischen Leiter 18, der im Stromkreis 14 angeordnet ist und einen ersten Anschluss 20 sowie einen zweiten Anschluss 22 aufweist. Die Anschlüsse 20, 22 können beispielsweise eine Bohrung 21, 23 für eine Schraubverbindung mit dem Stromkreis 14 aufweisen.

Des Weiteren weist der Batteriesensor 10 eine erste Strommesseinrichtung 24 sowie eine zweite Strommesseinrichtung 25 auf, die den über den elektrischen Leiter 18 fließenden Strom ermitteln können.

Die erste Strommesseinrichtung 24 weist einen Hallsensor 26 mit einem ersten Hallzelle 28 und einer zweiten Hallzelle 30 auf. Der elektrische Leiter 18 weist im Bereich des Hallsensors 26 eine Einschnürung 32 auf, die durch zwei sich von gegenüberliegenden Rändern des elektrischen Leiters erstreckenden Schlitze 34 gebildet ist.

Die Schlitze 34 sind bezüglich einer in Längsrichtung L des elektrischen Leiters verlaufenden Mittelachse 36 symmetrisch angeordnet. Die Schlitze 34 sind so angeordnet, dass sich jeweils eine der Hallzellen 28, 30 des Hallsensor 26 in einem der Schlitze 34 befindet, bzw. in unmittelbarer Nähe zu diesem angeordnet ist.

Durch den Strom, der durch den elektrischen Leiter 18 fließt, entsteht um den elektrischen Leiter 18 und in der Einschnürung 32 ein Magnetfeld, das vom Hallsensor 26 erfasst werden kann. Das Magnetfeld ändert sich mit dem Strom, der durch den elektrischen Leiter 18 fließt, sodass aus der Stärke des Magnetfeldes bzw. der Veränderung des Magnetfeldes der durch den elektrischen Leiter 18 fließende Strom bestimmt werden kann. Üblicherweise wird um den elektrischen Leiter 18 ein Eisenkern angeordnet, um ein ausreichend starkes Magnetfeld bereitzustellen, dass vom Hallsensor 26 erfasst werden kann. **In** der hier gezeigten Ausführungsform wird anstelle eines Eisenkerns eine Einschnürung 32 verwendet, in der der Hallsensor 26 angeordnet ist. Der Hallsensor 26 ist ein sogenannter Differenz- Hallsensor, durch den das durch den Strom entstehende Magnetfeld in der Einschnürung 32 erfasst werden kann. Dadurch kann auf einen zusätzlichen Eisenkern verzichtet werden.

Der Hallsensor 26 ist über eine Kommunikationsleitung 38 mit einer ersten Auswerteschaltung 40 verbunden. Die Auswerteschaltung 40 kann die vom Hallsensor 26 über die Kommunikationsleitung 38 empfangenen Messwerte des Hallsensors 26 empfangen, auswerten und aus diesen ein Strommesssignal erzeugen, das beispielsweise proportional zum über den elektrischen Leiter 18 fließenden Strom ist.

Die Auswerteschaltung 40 weist hierzu einen ersten Analog-Digital-Wandler 42 sowie einen ersten Mikrocontroller 44 auf. Die vom Mikrocontroller 44 erzeugten Strommesssignale können anschließend über eine erste Kommunikationsschnittstelle 46 ausgegeben werden, beispielsweise an eine nachgeordnete Fahrzeugsteuerung.

Die zweite Strommesseinrichtung 25 weist einen im Strompfad angeordneten Messwiderstand 48 auf. **In** Längsrichtung **L,** also in Stromrichtung vor und hinter dem Messwiderstand 48 sind ein erster Messkontakt 50 sowie ein zweiter Messkontakt 52 vorgesehen, die jeweils ein Spannungspotenzial am elektrischen Leiter 18 erfassen können. Die Messkontakte 50, 52 sind über Kommunikationsleitungen 54, 56 mit der ersten Auswerteschaltung 40 verbunden. Die Auswerteschaltung 40 weist einen zweiten Analog-Digital-Wandler 58 auf, der mit dem Mikrocontroller 44 verbunden ist.

Über den Analog-Digital-Wandler 58 sowie den Mikrokontroller 44 kann aus den Spannungspotenzialen der Messkontakte 50, 52 die über eine zwischen den Messkontakten 50, 52 definierte Messstrecke bzw. die über dem Messwiderstand 48 abfallende Spannung gemessen werden. Aus diesem Spannungsabfall sowie dem bekannten Widerstand der Messstrecke bzw. des Messwiderstandes 48 kann über das ohmsche Gesetz der über die Messstrecke bzw. den Messwiderstand 48 fließende Strom, also der über den elektrischen Leiter 18 fließende Strom, berechnet werden.

Der Mikrokontroller 44 kann die aus den Messwerten der ersten Strommesseinrichtung 24 sowie der zweiten Strommesseinrichtung 25 ermittelten Strommesssignale einzeln oder gemeinsam an die Kommunikationsschnittstelle 46 ausgeben, sodass diese an eine Fahrzeugsteuerung ausgegeben werden können.

Zusätzlich können im Mikrocontroller 44 weitere Anpassungen der Messwerte und/oder der Strommesssignale erfolgen, beispielsweise eine Kalibrierung oder eine Temperaturkompensation.

Wie insbesondere in Figur 1 zu sehen ist, ist eine Potenzialtrennzone 60 vorgesehen, um einen Spannungsüberschlag zwischen den mit dem elektrischen Leiter 18 in Kontakt stehenden Bereichen des Stromsensors 10 und einer Fahrzeugelektronik bzw. einer Fahrzeugsteuerung zu vermeiden. Die Potenzialtrennzone weist eine Schutzeinrichtung 62 auf, um die Strommesssignale an eine Fahrzeugelektronik oder eine Fahrzeugsteuerung bei einem ausreichend hohen Schutz gegen einen Spannungsüberschlag übertragen zu können. Beispielsweise kann das die Kommunikationsschnittstelle 46 auch in das Schutzeinrichtung 62 integriert sein.

Die erste Auswerteschaltung 40 weist des Weiteren eine Korrekturschaltung 64 auf, über die bei einer Fehlfunktion der Auswerteschaltung 40 geeignete Maßnahmen initiiert werden können, um die Fehlfunktion der Auswerteschaltung 40 zu beheben. Beispielsweise kann die Korrekturschaltung 64 einen Neustart oder ein Zurücksetzen der Auswerteschaltung 40 bewirken.

Des Weiteren ist eine zweite Auswerteschaltung 66 vorgesehen, die über eine Kommunikationsverbindung 68 mit der ersten Auswerteschaltung 40 verbunden ist. Die Kommunikationsverbindung 68 ist beispielsweise eine bidirektionale Kommunikationsleitung, über die Informationen zwischen der ersten Auswerteschaltung 40 und der zweiten Auswerteschaltung 66 ausgetauscht werden können.

Des Weiteren weist die zweite Auswerteschaltung 66 eine zweite Korrekturschaltung 70 sowie zumindest einen Eingang 72 für Betriebsinformationen des Stromsensors 10, beispielsweise des Mikrocontroller 44, der Auswerteschaltung 40, der ersten Strommesseinrichtung 24 und/oder der zweiten Strommesseinrichtung 25, auf. Der Eingang 72 ist mit einem Analog-Digital-Wandler 74 verbunden.

Über die Kommunikationsverbindung 68 können die erste Auswerteschaltung 40 und die zweite Auswerteschaltung 66 Informationen austauschen, um den ordnungsgemäßen Betriebszustand der jeweils anderen Auswerteschaltung 66, 40 zu prüfen. Vorzugsweise senden die Auswerteschaltung 40, 66 jeweils über die Kommunikationsverbindung 68 ein Testsignal mit vorab definierten Informationen, die von der jeweils anderen Auswerteschaltung 66, 40 überprüft werden. Stimmen die in dem Testsignal enthaltenen Informationen nicht mit den Informationen überein, die in der Auswerteschaltung 66, 40 gespeichert sind oder von dieser empfangen oder ermittelt werden, wird ein Korrektursignal an die Korrekturschaltung 64, 70 der jeweils anderen Auswerteschaltung 40, 66 gesendet. Beispielsweise wird auf Grundlage dieses Korrektursignals die jeweilige Auswerteschaltung 40, 66 neu gestartet oder zurückgesetzt.

Beispielsweise können die Testsignale Betriebsinformationen oder Statusinformationen der ersten Strommesseinrichtung 24, der zweiten Strommesseinrichtung 25 und/oder der jeweils anderen Auswerteschaltung 40, 66 enthalten.

Sind in dem Testsignal Betriebsinformationen oder Statusinformationen der ersten Strommesseinrichtung 24 und/oder der zweiten Strommesseinrichtung 25 enthalten, können diese von beiden Auswerteschaltungen 40, 66 empfangen und verarbeitet bzw. ausgewertet werden. Anschließend können die verarbeiteten oder ausgewerteten Betriebsinformationen oder Statusinformationen mit dem Testsignal über die Kommunikationsverbindung der jeweils anderen Auswerteschaltung 40, 66 übermittelt werden. Diese kann die in dem Testsignal enthaltenen Informationen mit den durch die eigene Auswerteschaltung 40, 66 ausgewerteten Informationen vergleichen. Weichen die ausgewerteten Informationen voneinander ab, muss davon ausgegangen werden, dass die Auswertung in der Auswerteschaltung 40, 66 fehlerhaft ist und somit die Auswerteschaltung 40, 66 nicht fehlerfrei arbeitet. Ist dies der Fall, kann anschließend durch die jeweils andere Auswerteschaltung 66, 40 ein Korrektursignal erzeugt und an die Auswerteschaltung 40, 66 gesendet werden.

Beispielsweise sind die Betriebsinformationen oder Statusinformationen Betriebsspannungen der ersten Strommesseinrichtung 24, der zweiten Strommesseinrichtung 25 und/oder der Auswerteschaltung in 40, 66. Beispielsweise werden die Betriebsspannung der Strommesseinrichtungen 24, 25 von der ersten Auswerteschaltung 40 bereitgestellt, sodass mit dem vorstehend beschriebenen Verfahren auch eine Überprüfung erfolgen kann, ob die korrekten Betriebsspannungen bereitgestellt werden. Insbesondere können in dieser Ausführungsform die Betriebsspannungen der Strommesseinrichtung 24, 25 direkt über einen Ausgang 74 an die zweite Auswerteschaltung 66 beziehungsweise den Eingang 72 der zweiten Auswerteschaltung 66 gesendet und von dieser überprüft werden.

Alternativ können die Testsignale auch Messwerte und/oder aus den Messwerten ermittelte Informationen, beispielsweise ein Strommesssignal, enthalten. Die von beiden Auswerteschaltungen 40, 66 empfangenen Messwerte und/oder die ausgewerteten Informationen können miteinander verglichen werden. Weichen diese voneinander ab, muss von einer Fehlfunktion der Auswerteschaltung 40, 66 ausgegangen werden.

Beispielsweise erfolgt das Senden der Testsignale periodisch in vorab definierten Zeitabständen. Das Ausbleiben eines Testsignals bzw. ein verzögertes Senden eines Testsignals kann dadurch ebenfalls als Fehlfunktion der jeweiligen Auswerteschaltung 40, 66 gewertet werden.

Insbesondere kann auch nach dem Senden des Korrektursignals und einem darauf folgenden Neustart oder einem Zurücksetzen der Auswerteschaltung 40, 66 unmittelbar ein erneutes Testsignal gesendet werden, um zu prüfen, ob der Neustart oder das Zurücksetzen der Auswerteschaltung 40, 66 erfolgreich war und die Fehlfunktion behoben wurde. Beispielsweise kann in einem solchen Fall auch über die Kommunikationsverbindung 68 ein Testsignal von der Auswerteschaltung 40, 66 angefordert werden.

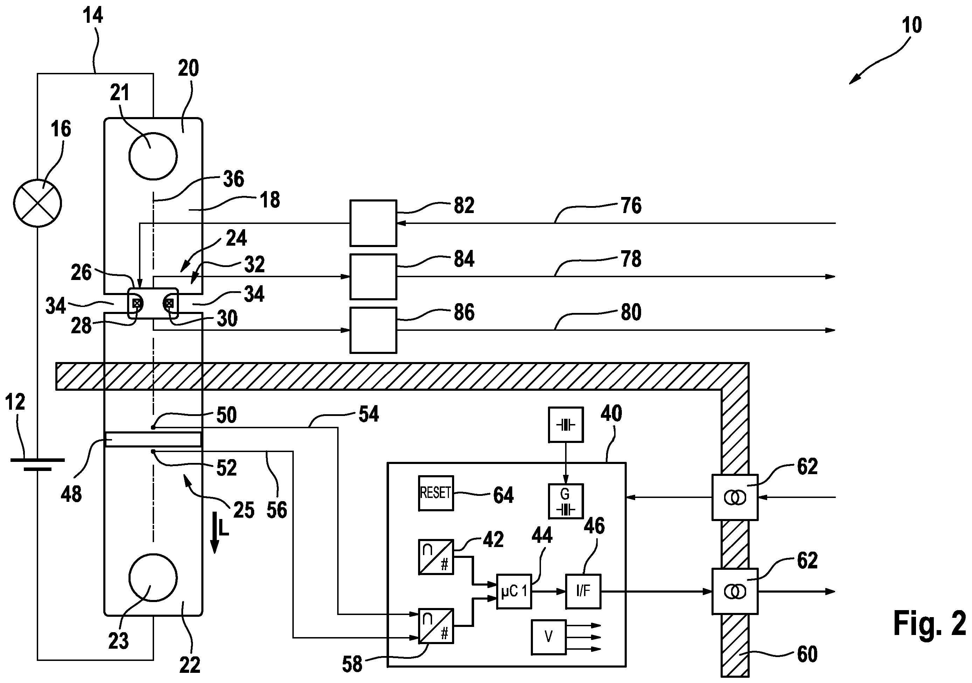

Die in Figur 2 gezeigte Ausführungsform weist ebenfalls einen elektrischen Leiter 18 mit einer ersten Strommesseinrichtung 24 und einer zweiten Strommesseinrichtung 25 auf. Die Funktionsweisen der Strommesseinrichtung 24, 25 entsprechen der in Figur eins gezeigten Ausführungsform. Die erste Strommesseinrichtung 24 weist einen Hall-Sensor 26 auf. Die zweite Strommesseinrichtung 25 weist einen Messwiderstand 48 sowie zwei Messkontakte 50, 52 auf. Des Weiteren ist eine erste Auswerteschaltung 40 vorgesehen, die mit den Messkontakten 50, 52 der zweiten Strommesseinrichtung 25 verbunden ist. Der Aufbau der ersten Auswerteschaltung 40 entspricht im Wesentlichen der in Figur 1 gezeigten ersten Auswerteschaltung 40.

Im Gegensatz zu der in Figur 1 gezeigten Ausführungsform hat der Hallsensor 26 aber eine separate Spannungsversorgung 76 sowie separate zweite Kommunikationsschnittstellen 78, 80 zur Ausgabe der Messwerte und/oder eines Fehlersignals, Betriebsinformationen und/oder Statusinformationen.

Die Kommunikationsschnittstelle 78 kann die Messwerte des Hallsensors 26 unverändert ausgegeben, beispielsweise an eine Fahrzeugsteuerung. In der Fahrzeugsteuerung können die Messwerte des Hallsensors 26 ausgewertet bzw. verarbeitet werden. Die ausgewerteten Messwerte des Hallsensors 26 können anschließend mit den über die erste Kommunikationsschnittstelle 46 ausgegebenen Strommesssignalen der zweiten Strommesseinrichtung 25 verglichen werden.

Wie in Figur 2 zu sehen ist, weisen die Kommunikationsschnittstellen 78, 80 sowie die Spannungsversorgung 76 Schutzeinrichtungen 82, 84, 86 gegen eine positive und/oder negative Überspannung auf.

Des Weiteren ist lediglich die erste Auswerteschaltung 40 in der Potenzialtrennzone 60 vorgesehen. Da die Messkontakte 50, 52 in direktem Kontakt mit dem elektrischen Leiter 18 stehen ist es auch in dieser Ausführungsform erforderlich, diese gegenüber den übrigen Bereichen des Stromsensors sowie ein gegenüber einer Fahrzeugsteuerung zu separieren bzw. zu isolieren. Da der Hallsensor 26 berührungslos misst und somit nicht in leitenden Kontakt mit dem elektrischen Leiter 18 steht, kann diese außerhalb der Potenzialtrennzone 60 angeordnet werden. Durch die Schutzeinrichtungen 82, 84, 86 ist dennoch ein zusätzlicher Schutz gegen eine positive und/oder negative Überspannung bereitgestellt.

Des Weiteren ist in der hier gezeigten Ausführungsform keine Kommunikationsverbindung 68 vorgesehen. Ein Vergleich der Messwerte, der Strommesssignale, der Betriebsinformationen und/oder der Statusinformationen kann in dieser Ausführungsform in der Fahrzeugsteuerung erfolgen. Aus diesem Grund werden beispielsweise über die Kommunikationsschnittstelle 80 Informationen, aus welchen ein Testsignal ermittelt werden kann, beispielsweise Fehlersignale, Betriebsinformationen oder Statusinformationen des Hallsensor 26 ausgegeben. Des Weiteren können die Informationen der ersten Auswerteschaltung 40 unverarbeitet oder als Testsignal über die erste Kommunikationsschnittstelle 46 ausgegeben werden.

## Patentansprüche

1. Stromsensor (10), insbesondere für eine Fahrzeugbatterie (12) in einem Fahrzeug, mit einem elektrischen Leiter (18), der einen ersten Anschluss (20) und einen zweiten Anschluss (22) zu Kontaktierung mit einem Stromkreis (14) eines Fahrzeugs aufweist, sowie mit einer ersten Strommesseinrichtung (24) und einer zweiten Strommesseinrichtung (25) zur Erfassung zumindest eines Messwertes für den über den elektrischen Leiter (18) fließenden Strom, wobei die zweite Strommesseinrichtung (25) elektrisch in Reihe zur ersten Strommesseinrichtung (24) angeordnet ist, und mit einer ersten Auswerteschaltung (40), die mit der ersten Strommesseinrichtung (24) und der zweiten Strommesseinrichtung (25) verbunden ist und die Messwerte der ersten Strommesseinrichtung (24) und der zweiten Strommesseinrichtung (25) empfangen und ein von den Messwerten abhängiges Strommesssignal ausgeben kann, wobei die erste Strommesseinrichtung (24) einen Hall-Sensor (26) aufweist und der elektrische Leiter (18) im Bereich der ersten Strommesseinrichtung (24) eine Messabschnitt mit einer Einschnürung (32) mit einem reduzierten Querschnitt aufweist, wobei der Hall-Sensor (26) in dieser Einschnürung (32) angeordnet ist,
wobei der Stromsensor (10) eine erste Kommunikationsschnittstelle (46) zur Ausgabe des Strommesssignals der zweiten Strommesseinrichtung (25) sowie eine zweite Kommunikationsschnittstelle (78) zur Ausgabe der Messwerte der ersten Strommesseinrichtung (24) aufweist, und
wobei der Stromsensor **dadurch gekennzeichnet ist, dass** eine zweite Auswerteschaltung (66) vorgesehen ist, wobei zwischen der ersten Auswerteschaltung (40) und der zweiten Auswerteschaltung (66) eine Kommunikationsverbindung (68) vorgesehen ist, wobei die erste Auswerteschaltung (40) ein erstes Testsignal an die zweite Auswerteschaltung (66) senden kann und die zweite Auswerteschaltung (66) ein zweites Testsignal an die erste Auswerteschaltung (40) senden kann, wobei die erste Auswerteschaltung (40) das zweite Testsignal prüfen und bei einer Abweichung des zweiten Testsignals von einem zweiten Referenzwert ein erstes Korrektursignal senden kann und wobei die zweite Auswerteschaltung (66) das erste Testsignal prüfen und bei einer Abweichung des ersten Testsignals von einem ersten Referenzwert ein zweites Korrektursignal senden kann.

2. Stromsensor nach Anspruch 1, **dadurch gekennzeichnet, dass** die Einschnürung (32) durch zumindest einen Schlitz (34) gebildet ist, der sich von zumindest einer Fläche und oder einem Rand des elektrischen Leiters (18) aus erstreckt.

3. Stromsensor nach einem der Ansprüche 1 und 2, **dadurch gekennzeichnet, dass** die Einschnürung (32) bezüglich einer in Längsrichtung (L) des elektrischen Leiters (18) verlaufenden Mittelachse (36) des elektrischen Leiters (18) symmetrisch, insbesondere bezüglich einer durch die Mittelachse (36) verlaufenden Ebene spiegelbildlich ausgebildet ist.

4. Stromsensor nach einem der vorhergehenden Ansprüche, **dadurch gekennzeichnet, dass** die zweite Strommesseinrichtung (25) einen Messwiderstand (48) aufweist sowie zumindest einen ersten Messkontakt (50) zur Erfassung eines ersten Spannungspotenzials und zumindest einen zweiten Messkontakt (52) zur Erfassung eines zweiten Spannungspotenzials, wobei die erste Messkontakt (50) und der zweite Messkontakt (52) in Längsrichtung (L) versetzt angeordnet sind.

5. Stromsensor nach Anspruch 1, **dadurch gekennzeichnet, dass** die erste Auswerteschaltung (40) eine erste Korrekturschaltung (64) zum Empfang des ersten Korrektursignal und/oder die zweite Auswerteschaltung (66) eine zweite Korrekturschaltung (70) zum Empfang des zweiten Korrektursignal aufweist, wobei die erste Korrekturschaltung (64) zum Auslösen eines Korrekturvorgangs für die erste Auswerteschaltung (40) und die zweite Korrekturschaltung (70) zum Auslösen eines Korrekturvorgangs für die zweite Auswerteschaltung (66) vorgesehen ist.

6. Stromsensor nach Anspruch 5, **dadurch gekennzeichnet, dass** der Korrekturvorgang der ersten und/oder der zweiten Auswerteschaltung (40, 66) einen Neustart der Auswerteschaltung (40, 66) und/oder ein Zurücksetzen der Auswerteschaltung (40, 66) umfasst.

7. Stromsensor nach einem der Ansprüche 1 bis 6, **dadurch gekennzeichnet, dass** das erste Testsignal Statusinformationen und/oder Betriebsinformationen der ersten Auswerteschaltung (40) und/oder das zweite Testsignal Statusinformationen und/oder Betriebsinformationen der zweiten Auswerteschaltung (66) beinhaltet.

8. Stromsensor nach einem der Ansprüche 1 bis 7, **dadurch gekennzeichnet, dass** das erste Testsignal Messwerte und/oder ein Strommesssignal der ersten Auswerteschaltung (40) und/oder das zweite Testsignal Messwerte und/oder ein Strommesssignal der zweiten Auswerteschaltung (66) beinhaltet.

9. Stromsensor nach einem der Ansprüche 1 bis 8, **dadurch gekennzeichnet, dass** das erste Testsignal und/oder das zweite Testsignal Statusinformationen und/oder Betriebsinformationen der ersten Strommesseinrichtung (24) und/oder der zweiten Strommesseinrichtung (25) beinhaltet.

10. Stromsensor nach einem der Ansprüche 1 bis 9, **dadurch gekennzeichnet, dass** die erste Auswerteschaltung (40) und die zweite Auswerteschaltung (66) separate Stromversorgungen und/oder separate Ausgänge für ein Strommesssignal aufweisen.

11. Stromsensor nach Anspruch 1, **dadurch gekennzeichnet, dass** die erste Kommunikationsschnittstelle (46) und/oder die zweite Kommunikationsschnittstelle (78) Schutzeinrichtungen (62, 84) gegen eine positive und/oder negative Überspannung und/oder für eine Potentialtrennung aufweist.

12. Stromsensor nach einem der vorhergehenden Ansprüche, **dadurch gekennzeichnet, dass** die erste Auswerteschaltung (40) und/oder die zweite Auswerteschaltung (66) eine Isolation, insbesondere eine galvanische Trennung, aufweisen.

## Claims

1. A current sensor (10), in particular for a vehicle battery (12) in a vehicle, with an electrical conductor (18) which has a first port (20) and a second port (22) for contacting an electrical circuit (14) of a vehicle, and with a first current measuring device (24) and a second current measuring device (25) for the detection of at least one measured value for the current flowing over the electrical conductor (18), wherein the second current measuring device (25) is arranged electrically in series with the first current measuring device (24), and with a first evaluation circuit (40) which is connected to the first current measuring device (24) and the second current measuring device (25) and can receive the measured values of the first current measuring device (24) and the second current measuring device (25) and output a current measuring signal depending on the measured values, wherein the first current measuring device (24) has a Hall effect sensor (26) and the electrical conductor (18) has a measuring section with a constriction (32) with a reduced cross section in the region of the first current measuring device (24), wherein the Hall effect sensor (26) is arranged in this constriction (32),
wherein the current sensor (10) has a first communication interface (46) for the output of the current measuring signal of the second current measuring device (25) and a second communication interface (78) for the output of the measured values of the first current measuring device (24), and
wherein the current sensor is **characterised in that** a second evaluation circuit (66) is provided, wherein a communication link (68) is provided between the first evaluation circuit (40) and the second evaluation circuit (66), wherein the first evaluation circuit (40) is able to send a first test signal to the second evaluation circuit (66) and the second evaluation circuit (66) is able to send a second test signal to the first evaluation circuit (40), wherein the first evaluation circuit (40) is able to check the second test signal and send a first correction signal in case of a deviation of the second test signal from a second reference value and wherein the second evaluation circuit (66) is able to check the first test signal and send a second correction signal in case of a deviation of the first test signal from a first reference value.

2. The current sensor as claimed in claim 1, **characterised in that** the constriction (32) is formed by at least one slot (34) which extends from at least a surface and/or an edge of the electrical conductor (18).

3. The current sensor as claimed in any one of claims 1 and 2, **characterised in that** the constriction (32) is configured so that it is symmetrical with respect to a central axis (36) of the electrical conductor (18) which runs in the longitudinal direction (L) of the electrical conductor (18), in particular mirror-symmetrical with respect to a plane which runs through the central axis (36).

4. The current sensor as claimed in any one of the preceding claims, **characterised in that** the second current measuring device (25) has a measuring resistor (48) and at least one first measuring contact (50) for the detection of a first voltage potential and at least one second measuring contact (52) for the detection of a second voltage potential, wherein the first measuring contact (50) and the second measuring contact (52) are arranged offset in the longitudinal direction (L).

5. The current sensor as claimed in claim 1, **characterised in that** the first evaluation circuit (40) has a first correction circuit (64) for the receipt of the first correction signal and/or the second evaluation circuit (66) has a second correction circuit (70) for the receipt of the second correction signal, wherein the first correction circuit (64) is provided for triggering a correction procedure for the first evaluation circuit (40) and the second correction circuit (70) is provided for triggering a correction procedure for the second evaluation circuit (66).

6. The current sensor as claimed in claim 5, **characterised in that** the correction procedure of the first and/or the second correction circuit (40, 66) comprise/s a restart of the evaluation circuit (40, 66) and/or a reset of the evaluation circuit (40, 66).

7. The current sensor as claimed in any one of claims 1 to 6, **characterised in that** the first test signal includes status information and/or operating information of the first evaluation circuit (40) and/or the second test signal includes status information and/or operating information of the second evaluation circuit (66).

8. The current sensor as claimed in any one of claims 1 to 7, **characterised in that** the first test signal includes measured values and/or a current measuring signal of the first evaluation circuit (40) and/or the second test signal includes measured values and/or a current measuring signal of the second evaluation circuit (66).

9. The current sensor as claimed in any one of claims 1 to 8, **characterised in that** the first test signal and/or the second test signal include/s status information and/or operating information of the first current measuring device (24) and/or the second current measuring device (25).

10. The current sensor as claimed in any one of claims 1 to 9, **characterised in that** the first evaluation circuit (40) and the second evaluation circuit (66) have separate current supplies and/or separate outlets for a current measuring signal.

11. The current sensor as claimed in claim 1, **characterised in that** the first communication interface (46) and/or the second communication interface (78) have/has protection devices (62, 84) against a positive and/or negative overvoltage and/or for potential separation.

12. The current sensor as claimed in any one of the preceding claims, **characterised in that** the first evaluation circuit (40) and/or the second evaluation circuit (66) have/has an insulation, in particular a galvanic isolation.

## Revendications

1. Capteur de courant (10), en particulier pour une batterie de véhicule (12) dans un véhicule, comprenant un conducteur électrique (18) qui comporte un premier raccordement (20) et un second raccordement (22) destinés à l'établissement d'un contact avec un circuit électrique (14) d'un véhicule, ainsi qu'un premier dispositif de mesure de courant (24) et un second dispositif de mesure de courant (25) pour la détection d'au moins une valeur mesurée du courant circulant à travers le conducteur électrique (18), dans lequel le second dispositif de mesure de courant (25) est disposé électriquement en série avec le premier dispositif de mesure de courant (24), et comprenant un premier circuit d'évaluation (40) qui est relié au premier dispositif de mesure de courant (24) et au second dispositif de mesure de courant (25), et qui est apte à recevoir les valeurs mesurées du premier dispositif de mesure de courant (24) et du second dispositif de mesure de courant (25) et à délivrer un signal de mesure de courant dépendant des valeurs mesurées, dans lequel le premier dispositif de mesure de courant (24) comporte un capteur à effet Hall (26), et le conducteur électrique (18) comporte, dans la zone du premier dispositif de mesure de courant (24), une section de mesure comportant un étranglement (32) présentant une section transversale réduite, dans lequel le capteur à effet Hall (26) est disposé dans ledit étranglement (32),
dans lequel le capteur de courant (10) comporte une première interface de communication (46) destinée à la sortie du signal de mesure de courant du second dispositif de mesure de courant (25), ainsi qu'une seconde interface de communication (78) destinée à la sortie des valeurs mesurées du premier dispositif de mesure de courant (24), et
dans lequel le capteur de courant est **caractérisé en ce qu'**un second circuit d'évaluation (66) est prévu, dans lequel une liaison de communication (68) est prévue entre le premier circuit d'évaluation (40) et le second circuit d'évaluation (66), dans lequel le premier circuit d'évaluation (40) peut envoyer un premier signal de test au second circuit d'évaluation (66), et le second circuit d'évaluation (66) peut envoyer un second signal de test au premier circuit d'évaluation (40), dans lequel le premier circuit d'évaluation (40) peut vérifier le second signal de test et, en cas d'écart du second signal de test par rapport à une seconde valeur de référence, envoyer un premier signal de correction, et dans lequel le second circuit d'évaluation (66) peut vérifier le premier signal de test et, en cas d'écart du premier signal de test par rapport à une première valeur de référence, envoyer un second signal de correction.

2. Capteur de courant selon la revendication 1, **caractérisé en ce que** l'étranglement (32) est formé par au moins une fente (34) qui s'étend à partir d'au moins une surface et/ou d'un bord du conducteur électrique (18).

3. Capteur de courant selon l'une des revendications 1 et 2, **caractérisé en ce que** l'étranglement (32) est formé de manière symétrique par rapport à un axe médian (36) du conducteur électrique (18) s'étendant dans la direction longitudinale (L) du conducteur électrique (18), en particulier de manière symétrique par rapport à un plan passant par ledit axe médian (36).

4. Capteur de courant selon l'une quelconque des revendications précédentes, **caractérisé en ce que** le second dispositif de mesure de courant (25) comporte une résistance de mesure (48) ainsi qu'au moins un premier contact de mesure (50) pour la détection d'un premier potentiel de tension et au moins un second contact de mesure (52) pour la détection d'un second potentiel de tension, dans lequel le premier contact de mesure (50) et le second contact de mesure (52) sont disposés de manière décalée dans la direction longitudinale (L).

5. Capteur de courant selon la revendication 1, **caractérisé en ce que** le premier circuit d'évaluation (40) comporte un premier circuit de correction (64) destiné à recevoir le premier signal de correction et/ou le second circuit d'évaluation (66) comporte un second circuit de correction (70) destiné à recevoir le second signal de correction, dans lequel le premier circuit de correction (64) est prévu pour déclencher un processus de correction pour le premier circuit d'évaluation (40) et le second circuit de correction (70) est prévu pour déclencher un processus de correction pour le second circuit d'évaluation (66).

6. Capteur de courant selon la revendication 5, **caractérisé en ce que** le processus de correction du premier et/ou du second circuit d'évaluation (40, 66) comprend un redémarrage du circuit d'évaluation (40, 66) et/ou une réinitialisation du circuit d'évaluation (40, 66).

7. Capteur de courant selon l'une quelconque des revendications 1 à 6, **caractérisé en ce que** le premier signal de test contient des informations d'état et/ou des informations de fonctionnement du premier circuit d'évaluation (40) et/ou le second signal de test contient des informations d'état et/ou des informations de fonctionnement du second circuit d'évaluation (66).

8. Capteur de courant selon l'une des revendications 1 à 7, **caractérisé en ce que** le premier signal de test contient des valeurs mesurées et/ou un signal de mesure de courant du premier circuit d'évaluation (40) et/ou le second signal de test contient des valeurs mesurées et/ou un signal de mesure de courant du second circuit d'évaluation (66).

9. Capteur de courant selon l'une quelconque des revendications 1 à 8, **caractérisé en ce que** le premier signal de test et/ou le second signal de test contient des informations d'état et/ou des informations de fonctionnement du premier dispositif de mesure de courant (24) et/ou du second dispositif de mesure de courant (25).

10. Capteur de courant selon l'une quelconque des revendications 1 à 9, **caractérisé en ce que** le premier circuit d'évaluation (40) et le second circuit d'évaluation (66) comportent des alimentations électriques séparées et/ou des sorties séparées pour un signal de mesure de courant.

11. Capteur de courant selon la revendication 1, **caractérisé en ce que** la première interface de communication (46) et/ou la seconde interface de communication (78) comportent des dispositifs de protection (62, 84) contre une surtension positive et/ou négative et/ou pour une isolation de potentiel.

12. Capteur de courant selon l'une quelconque des revendications précédentes, **caractérisé en ce que** le premier circuit d'évaluation (40) et/ou le second circuit d'évaluation (66) comportent une isolation, en particulier une séparation galvanique.
